# NOUVEAU FASCICULE DE BREVET EUROPEEN

(11) **EP 0 689 165 B2**
(45) Date de publication et mention de la décision concernant l'opposition: **29.01.2003**
(45) Mention de la délivrance du brevet: 24.02.1999
(21) Numéro de dépôt: 95401458.5
(22) Date de dépôt: 20.06.1995
(51) Int. Cl.: G06K 19/077

(54) **Carte à mémoire sans contact dont le circuit électronique comporte un module**
Kontaktlose Speicherkarte mit IC-Modul
Contactless memory card with IC-module

(30) Priorité: 22.06.1994 FR 9407657
(43) Date de publication de la demande: 27.12.1995
(73) Titulaire: SCHLUMBERGER Systèmes, 92120 Montrouge (FR)
(72) Inventeur: Gaumet, Michel, F-45560 Saint-Denis-En-Val (FR); Larchevesque, Alain, F-45160 Ferolles (FR)
(74) Mandataire: Bugnon-Hays, Claudine

(56) Documents cités:
- EP-A- 0 094 716
- EP-A- 0 116 148
- EP-A- 0 488 574
- EP-A- 0 682 321
- FR-A- 2 686 996

## Description

La présente invention concerne une carte à mémoire sans contact pourvue d'un circuit électronique inaccessible physiquement de l'extérieur et comprenant, sur un film isolant, des composants électroniques reliés par des éléments conducteurs.

Les cartes à mémoire sans contact sont actuellement chères à fabriquer, surtout lorsqu'elles sont pourvues d'un circuit électronique complexe. Leur fabrication nécessite en effet des installations sophistiquées imposant de gros investissements et ayant cependant des cadences de production limitées.

Un exemple de carte à mémoire sans contact est divulgué dans EP-A-0488574. Ce document sert de base au préambule de la revendication 1.

Par ailleurs, le document EP-A-682 321 publié après le dépôt du présent brevet mais bénéficiant d'une date de priorité antérieure décrit une carte sans contact comprenant un module à circuit intégré fixé à une antenne portée par un film isolant.

Le module utilisé dans la carte à mémoire sans contact selon l'invention est un produit semi-fini du type de ceux qui sont fabriqués en très grande série et à cadence élevée pour les cartes à mémoire classiques dont les contacts sont apparents.

Il est donc possible de le fabriquer de façon très économique en utilisant les mêmes techniques que celles avec lesquelles on fabrique actuellement les modules des cartes classiques.

Son montage dans le circuit électronique des cartes à mémoire sans contact peut par ailleurs être automatisé, ce qui permet de fabriquer ces cartes à cadence élevée et à faible prix de revient.

Le module doit être fixé contre les éléments conducteurs du film isolant dans une position précise prédéterminée pour que la carte à mémoire puisse fonctionner convenablement.

Lorsque les modules sont stockés avec leur circuit imprimé tourné vers le haut, leur positionnement correct sur le film isolant est réalisable sans difficulté. Dans ce cas, il suffit en effet de prendre comme repère un élément particulier de leur circuit imprimé qui a une structure dissymétrique pour les déposer dans la position correcte sur le film isolant.

En revanche, lorsque les modules sont stockés avec leur circuit imprimé tourné vers le bas, leur mise en place correcte sur le film isolant demande beaucoup de temps puisque leur circuit imprimé n'est pas repérable directement.

Le document EP-A-682 321 ne prévoit aucune disposition permettant un positionnement précis du module. Selon l'invention on prévoit une carte à mémoire sans contact pourvue d'un circuit électronique inaccessible physiquement de l'extérieur et comprenant, sur un film isolant, des composants électroniques reliés par des éléments conducteurs, caractérisée en ce que l'un au moins des composants du circuit électronique est constitué par un module comprenant un support isolant pourvu de trous, un circuit imprimé situé sur l'une des faces du support isolant, un circuit intégré situé du côté de l'autre face du support isolant et relié électriquement au circuit imprimé par des fils conducteurs traversant des trous du support isolant, une matière isolante de protection enrobant le circuit intégré et les fils conducteurs, et un repère sur sa face opposée au circuit imprimé, le circuit imprimé de ce module étant retenu par une matière conductrice contre les éléments conducteurs portés par le film isolant.

Ainsi, grâce à ce repère, le module peut être correctement mis en place sur le film isolant sans le moindre tâtonnement, ce qui permet d'augmenter les cadences de production des cartes.

De préférence, le repère est constitué par au moins un perçage ménagé dans le support isolant, ce perçage pouvant être obturé par le circuit imprimé.

La carte à mémoire sans contact selon l'invention est par ailleurs caractérisée en ce que le film isolant est pourvu, sur sa face portant les composants électroniques, d'une couche de matière isolante recouvrant ces derniers, cette couche protégeant parfaitement le circuit électronique contre les agressions extérieures.

Afin d'améliorer encore la protection du circuit électronique, l'autre face du film isolant peut également être pourvue d'une seconde couche de matière isolante.

Un mode d'exécution de la présente invention sera décrit ci-après à titre d'exemple nullement limitatif en référence aux dessins annexés dans lesquels :
- la figure 1 est une vue de dessus d'un module destiné à être incorporé dans le circuit électronique d'une carte à mémoire sans contact conforme à l'invention ;
- la figure 2 est une vue en coupe selon la ligne II-II de la figure 1;
- la figure 3 est une vue de dessous du module visible sur la figure 1 ;
- la figure 4 est une vue schématique en coupe partielle d'une carte à mémoire sans contact conforme à l'invention, le module visible sur les figures 1 à 3 constituant l'un des composants du circuit électronique de cette carte ;
- la figure 5 est une vue en coupe d'un module selon une première variante, cette vue étant analogue à celle visible sur la figure 2 ;
- la figure 6 est une vue de dessous du module représenté en coupe sur la figure 5 ; et
- la figure 7 est une vue en coupe d'un module selon une seconde variante de réalisation.

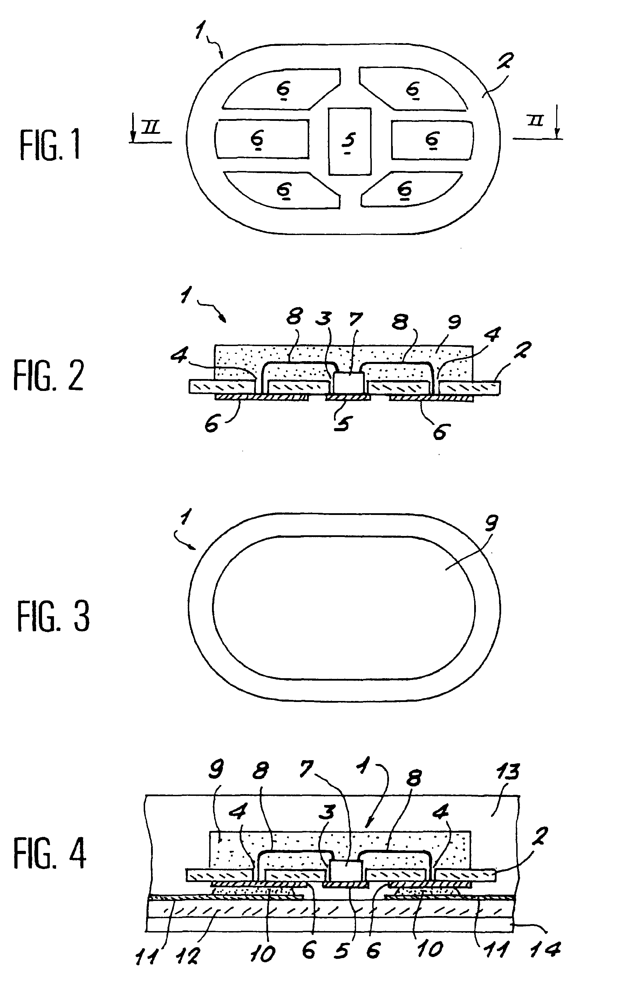

Le module 1 que l'on peut voir sur les figures 1 à 3 comprend un support isolant 2 pourvu d'un trou central 3 et de trous périphériques 4, un circuit imprimé constitué d'un élément conducteur central 5 et d'éléments conducteurs latéraux 6 portés par l'une des faces du support isolant 2, un circuit intégré 7 fixé sur l'élément conducteur central 5, du côté du trou central 3, et relié électriquement aux éléments conducteurs latéraux 6 par des fils conducteurs 8 traversant les trous périphériques 4, et une matière isolante de protection 9 enrobant le circuit intégré 7 et les fils conducteurs 8.

Le support isolant 2 est réalisé en matière plastique, de préférence en polyimide ou en époxy renforcé par des fibres de verre. Les conducteurs 5 et 6 du circuit imprimé peuvent quant à eux être réalisés par exemple par gravure ou dépôt électrolytique de couches métalliques, ou par dépôt par sérigraphie d'une encre conductrice.

Conformément à l'invention, les éléments conducteurs latéraux 6 sont reliés, par l'intermédiaire d'une colle conductrice 10, à des éléments conducteurs 11 déposés sur l'une des faces d'un film isolant 12 et qui, tout comme le module 1, font partie du circuit électronique de la carte à mémoire sans contact représentée en coupe partielle et schématique sur la figure 4.

Le circuit électronique de cette carte comporte un certain nombre de composants électroniques (non représentés) autres que le module 1, ces composants pouvant par exemple être constitués par des condensateurs, des résistances, des antennes, etc...

Il est inaccessible physiquement de l'extérieur. En effet, dans l'exemple représenté sur la figure 4, le corps de la carte est constitué de deux couches de matière plastique isolante 13,14 fixées respectivement contre les deux faces du film isolant 12.

Le module 1 peut être rapidement fixé dans la position adéquate contre les éléments conducteurs 11 lorsqu'il est stocké avec son circuit imprimé tourné vers le haut. Dans ce cas, l'opérateur peut en effet utiliser l'un des éléments conducteurs 5,6 du circuit imprimé comme repère pour identifier sans hésitation la position dans laquelle il doit fixer le module contre les éléments conducteurs.

En revanche, lorsque le module est stocké avec son circuit imprimé tourné vers le bas, l'opérateur a besoin de plus de temps pour identifier la position de fixation dudit module.

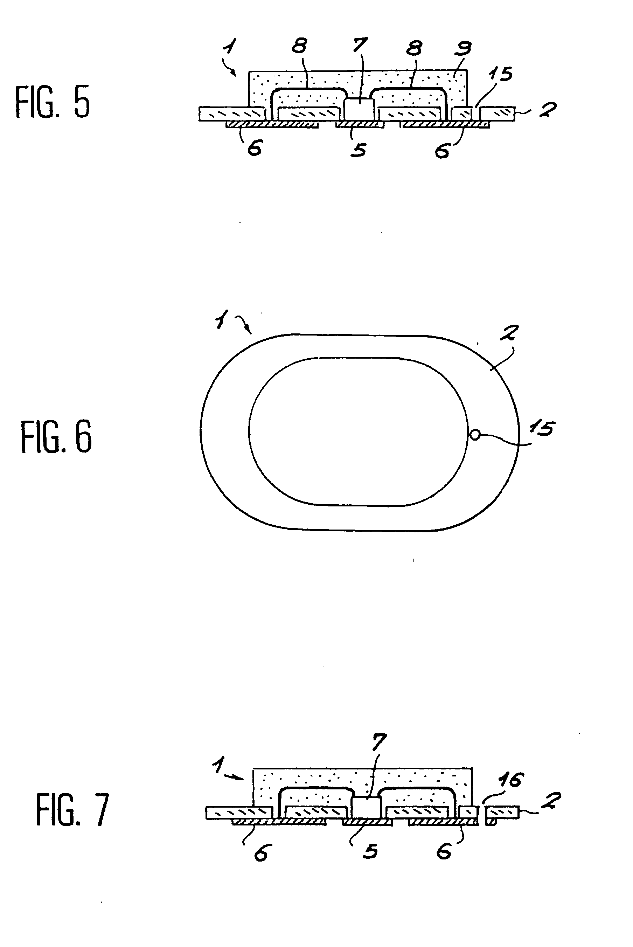

Afin de faciliter cette identification, le support isolant 2 du module peut être pourvu d'un ou de plusieurs perçages 15 dont l'une des extrémités est obturée par l'un des éléments conducteurs 6 du circuit imprimé, comme représenté sur la figure 5. En variante, le support 2 et l'un des éléments conducteurs 6 peuvent être pourvus d'un perçage 16, comme représenté sur la figure 7.

On conçoit aisément que grâce au perçage 15 ou 16, l'opérateur dispose d'un repère lui permettant d'identifier sans tâtonnement la position dans laquelle il doit présenter le module 1 pour le fixer dans la position adéquate contre les éléments conducteurs 11.

II va de soi que la fixation du module 1 contre les éléments conducteurs 11 pourrait être automatisée, l'installation utilisée pouvant avantageusement comporter des moyens de détection capables de repérer un élément conducteur particulier du circuit imprimé, ou le perçage 15 ou 16 réalisé dans le support isolant 2.

## Revendications

1. Carte à mémoire sans contact pourvue d'un circuit électronique inaccessible physiquement de l'extérieur et comprenant, sur un film isolant (12), des composants électroniques reliés par des éléments conducteurs (11), **caractérisée en ce que** l'un au moins des composants du circuit électronique est constitué par un module (1) comprenant un support isolant (2) pourvu de trous (3, 4), un circuit imprimé (5, 6) situé sur l'une des faces du support isolant, un circuit intégré (7) situé du côté de l'autre face du support isolant et relié électriquement au circuit imprimé par des fils conducteurs (8) traversant des trous du support isolant, une matière isolante de protection (9) enrobant le circuit intégré et les fils conducteurs, et un repère (15, 16) sur sa face opposée au circuit imprimé, le circuit imprimé de ce module étant retenu par une matière conductrice (10) contre les éléments conducteurs (11) portés par le film isolant (12).

2. Carte à mémoire selon la revendication 1, **caractérisée en ce que** le repère est constitué par au moins un perçage (15, 16) ménagé dans le support isolant (2).

3. Carte à mémoire selon la revendication 2, **caractérisée en ce que** le perçage (15) est obturé par le circuit imprimé.

4. Carte à mémoire selon l'une quelconque des revendications précédentes, **caractérisée en ce que** le film isolant (12) est pourvu sur sa face portant les composants électroniques d'une couche de matière isolante (13) recouvrant ces derniers.

5. Carte à mémoire selon la revendication 4, **caractérisée en ce que** l'autre face du film isolant (12) est pourvue d'une seconde couche de matière isolante (14).

## Claims

1. A contactless memory card provided with an electronic circuit that is physically inaccessible from the outside and comprising, on an insulating film (12), electronic components connected by conductive elements (11), the memory card being **characterized in that** at least one of the components of the electronic circuit is constituted by a module (1) comprising an insulating support (2) provided with holes (3, 4), a printed circuit (5, 6) situated on one of the faces of the insulating support, an integrated circuit (7) situated on the same side as the other face of the insulating support and electrically connected to the printed circuit via conductive wires (8) passing through the holes of the insulating support, a protective insulating material (9) coating the integrated circuit and the conductive wires, and a reference point (15, 16) on its face opposite to its printed circuit face, the printed circuit of said module being held by a conductive material (10) against the conductive elements (11) carried by the insulating film (12).

2. A memory card according to claim 1, **characterized in that** the reference point is constituted by at least one hole (15, 16) made in the insulating support (2).

3. A memory card according to claim 2, **characterized in that** the hole (15) is closed by the printed circuit.

4. A memory card according to any preceding claim, **characterized in that** the insulating film (12) is provided, on its face carrying the electronic components, with a layer of insulating material (13) covering said components.

5. A memory card according to claim 4, **characterized in that** the other face of the insulating film (12) is provided with a second layer of insulating material (14).

## Patentansprüche

1. Kontaktlose Speicherkarte, die mit einer von außen physisch unzugänglichen elektronischen Schaltung versehen ist und auf einer Isolierfolie (12) elektronische Bauteile enthält, die mit leitenden Elementen (11) verbunden sind, **dadurch gekennzeichnet, daß** mindestens eines der Bauteile der elektronischen Schaltung aus einem Modul (1) besteht, das einen mit Löchern (3, 4) versehenen Isolierträger (2), eine auf der einen Seite des Isolierträgers angeordnete gedruckte Schaltung (5, 6), eine auf der anderen Seite des Isolierträgers angeordnete und elektrisch über durch Löcher des Isolierträgers hindurchgehende Leiterdrähte (8) mit der gedruckten Schaltung verbundene integrierte Schaltung (7), ein isolierendes Schutzmaterial (9), das die integrierte Schaltung und die Leiterdrähte umgibt, sowie auf seiner der gedruckten Schaltung gegenüberliegenden Seite eine Markierung (15, 16) enthält, wobei die gedruckte Schaltung dieses Moduls mittels eines leitenden Materials (10) gegen die von der Isolierfolie (12) getragenen leitenden Elemente (12) gehalten wird.

2. Speicherkarte nach Anspruch 1, **dadurch gekennzeichnet, daß** die Markierung aus mindestens einer im Isolierträger (2) angebrachten Bohrung (15, 16) besteht.

3. Speicherkarte nach Anspruch 2, **dadurch gekennzeichnet, daß** die Bohrung (15) durch die gedruckte Schaltung verschlossen ist.

4. Speicherkarte nach einem der vorhergehenden Ansprüche, **dadurch gekennzeichnet, daß** die Isolierfolie (12) auf seiner die elektronischen Bauteile tragenden Seite mit einer Schicht aus isolierendem Material (13) versehen ist, die diese elektronischen Bauteile überdeckt.

5. Speicherkarte nach Anspruch 4, **dadurch gekennzeichnet, daß** die andere Seite der Isolierfolie (12) mit einer zweiten Schicht aus isolierendem Material (14) versehen ist.
